(19) Europäisches Patentamt
European Patent Office
Office européen des brevets

(11) **EP 4 753 218 A1**

(12) **EUROPEAN PATENT APPLICATION**

(43) Date of publication:
03.06.2026 Bulletin 2026/23

(21) Application number: 25216446.2

(22) Date of filing: 17.11.2025

(51) International Patent Classification (IPC):
*H04L 27/14* (2006.01)    *H04L 27/06* (2006.01)
*H04L 27/156* (2006.01)

(52) Cooperative Patent Classification (CPC):
**H04L 27/14;** H04L 27/06; H04L 27/1563

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **02.12.2024 US 202418965799**

(71) Applicant: **STMicroelectronics International N.V.
1228 Plan-les-Ouates, Geneva (CH)**

(72) Inventors:
• **PORCARO, Carlo**
**I-89135 Reggio Calabria (IT)**
• **VITALI, Andrea Lorenzo**
**San Jose, 95126, CA (US)**
• **CIRILLO, Giovanni Amedeo**
**I-10128 Torino (IT)**

(74) Representative: **Buzzi, Notaro & Antonielli d'Oulx
S.p.A.
Corso Vittorio Emanuele II, 6
10123 Torino (IT)**

(54) **GLITCH REJECTION FOR FSK DEMODULATION**

(57) According to an embodiment, a glitch rejection circuit includes a first stage averaging circuit with programmable length, a second stage averaging circuit, and a hysteresis comparator. The first stage implements a recursive moving sum average using a FIFO buffer to process a binary input signal. The second stage provides moving average filtering. The hysteresis comparator uses programmable thresholds set based on peak signal values to generate a clean output signal. The circuit removes glitches from frequency-shift keying (FSK) demodulator input signals while maintaining signal integrity at high bitrates. The programmable parameters allow optimization based on expected glitch characteristics and system requirements.

FIG. 2

EP 4 753 218 A1

Processed by Luminess, 75001 PARIS (FR)

## Description

### TECHNICAL FIELD

The present disclosure generally relates to demodulation and, in particular embodiments, to glitch rejection for high bitrate FSK demodulators.

### BACKGROUND

In wireless power transfer systems, communication between transmitter and receiver devices often employs frequency-shift keying (FSK) modulation. FSK modulation encodes digital information by varying the frequency of a carrier signal. For wireless charging applications, the transmitter may modulate its power signal frequency to transmit data to the receiver.

FSK demodulation circuits in the receiver extract the transmitted information from the modulated power signal. One approach to FSK demodulation uses a counter-based method, which measures the frequency of the incoming FSK signal by counting cycles of a known system clock within each period of the FSK signal. The resulting count values correspond to the transmitted frequencies and can be used to determine the digital data.

The voltage from the receiver's rectifier circuit is used as an input to the FSK demodulation process. However, this voltage can contain glitches-unwanted short-duration pulses or transitions. The glitches may occur near the boundaries of frequency transitions and can result from factors such as component selection, coil coupling, and load characteristics. Glitches in the input signal can pose challenges for accurate FSK demodulation, particularly at higher data rates.

### SUMMARY

Technical advantages are generally achieved by embodiments of this disclosure, which describe glitch rejection for high bitrate FSK demodulators.

A first aspect relates to a circuit for glitch rejection in a frequency-shift keying (FSK) demodulator, the circuit configured to receive a binary input signal sampled at a system frequency, the circuit comprising a first stage averaging circuit with a programmable length; a second stage averaging circuit coupled to an output of the first stage averaging circuit; and a hysteresis comparator coupled to an output of the second stage averaging circuit, wherein the circuit is configured to output a glitch-free clock signal.

A second aspect relates to a system for high bitrate frequency-shift keying (FSK) demodulation, the system comprising a glitch rejection circuit configured to receive an input signal from a zero-crossing comparator and generate a glitch-free output, the glitch rejection circuit comprising a first stage averaging circuit with a programmable length, a second stage averaging circuit coupled to an output of the first stage averaging circuit, and a hysteresis comparator with programmable high and low thresholds; a conditioning circuit configured to perform a blanking operation, perform a filtering operation, or be bypassed in response to the operational mode of the conditioning circuit; and an FSK demodulator counter circuit configured to receive the glitch-free output from the glitch rejection circuit. A third aspect relates to a method for glitch rejection in a frequency-shift keying (FSK) demodulator, the method comprising receiving a binary input signal sampled at a system frequency; processing the binary input signal through a first stage averaging circuit with a programmable length; processing an output of the first stage averaging circuit through a second stage averaging circuit; applying a hysteresis comparator to an output of the second stage averaging circuit; and outputting a glitch-free clock signal for use by a counter in the FSK demodulator. Embodiments can be implemented in hardware, software, or any combination thereof.

### BRIEF DESCRIPTION OF THE DRAWINGS

For a more complete understanding of the present disclosure and the advantages thereof, reference is now made to the following descriptions taken in conjunction with the accompanying drawings, in which:

Figure 1 is a block diagram of an embodiment wireless power system;

Figure 2 is a block diagram of an embodiment receiving device;

Figure 3 is a block diagram of an embodiment circuit;

Figure 4 is a block diagram of a glitch rejection circuit;

Figure 5 is a flowchart of an embodiment method for glitch rejection in FSK demodulation;

Figure 6 is a block diagram of an embodiment first moving average (MA) stage;

Figure 7 is a block diagram of an embodiment second moving average (MA) stage;

Figure 8 is a block diagram of an embodiment hysteresis comparator stage;

Figure 9 is a block diagram of a first synchronization circuit; and

Figure 10 is a block diagram of a second synchronization circuit.

## DETAILED DESCRIPTION OF ILLUSTRATIVE EMBODIMENTS

This disclosure provides many applicable inventive concepts that can be embodied in a wide variety of specific contexts. The particular embodiments are merely illustrative of specific configurations and do not limit the scope of the claimed embodiments. Features from different embodiments may be combined to form further embodiments unless noted otherwise. Various embodiments are illustrated in the accompanying drawing figures, where identical components and elements are identified by the same reference number, and repetitive descriptions are omitted for brevity.

Variations or modifications described in one of the embodiments may also apply to others. Further, various changes, substitutions, and alterations can be made herein without departing from the spirit and scope of this disclosure as defined by the appended claims.

While the inventive aspects are described primarily in the context of wireless power transfer systems, particularly those used in personal electronics and embedded applications such as smartphones, tablets, headphones, earbuds, and smartwatches, it should also be appreciated that these inventive aspects may also apply to other communication systems.

The glitch rejection techniques described herein can be particularly beneficial in compact electronic devices where efficient power transfer and reliable communication are advantageous. In particular, aspects of this disclosure may similarly apply to any digital communication system where high-bitrate FSK demodulation is employed in the presence of signal glitches or noise, extending beyond wireless charging to potentially include other short-range wireless communication protocols used in consumer electronics and Internet of Things (IoT) devices.

Embodiments of the disclosure provide a system for glitch rejection in frequency-shift keying (FSK) demodulators, which can be particularly advantageous for high-bitrate applications. A proposed system implements a normalized low-pass filter that can operate at high frequencies while maintaining programmability and efficiency. The filter includes a first stage moving average circuit with a programmable length, a second stage moving average circuit, and a hysteresis comparator with programmable thresholds.

In embodiments, the first stage of the filter utilizes a recursive moving sum average technique, which can be implemented using an accumulator and a first-in-first-out (FIFO) buffer. This stage processes the binary input signal sampled at the system frequency, incrementing the accumulator for each logic one sampled and decrementing it when no logic one is present in the sliding window.

The second stage of the filter further refines the signal using a moving average, which can be implemented as a three-point average. This stage helps to smooth out any residual glitches.

The final stage employs a hysteresis comparator with programmable high and low thresholds. These thresholds can be adjusted based on the relationship between the duty cycle of the input signal and the length of the moving average window, allowing for optimal glitch rejection across various input conditions.

The output of this glitch rejection circuit provides a clean clock signal for the counter in the FSK demodulator. By removing glitches from the input signal, the system advantageously enables accurate frequency measurement even at high bitrates and system clock frequencies.

Aspects of the disclosure also include techniques for setting the filter parameters. The length of the first stage moving average can be programmed based on the maximum glitch width to be rejected. The hysteresis thresholds can be set as a function of the peak value of the moving average output, which can depend on the relationship between the duty cycle of the input signal and the moving average length.

As used throughout this disclosure, the terms "averaging circuit" and "averaging" refer to any circuit or operation that processes a series of input samples to produce an output based on multiple samples, including but not limited to moving sum implementations without division and true moving average implementations with division. The division operation in true moving average implementations may be accomplished through various means, including but not limited to the use of barrel shifters, multiplication by fixed-point numbers storing reciprocals of averaging lengths, or dedicated division circuits. While specific embodiments may be described with reference to particular implementations, such as moving sum averaging without division, the claims are not limited to such implementations unless explicitly stated.

Various embodiments disclosed offer advantages over traditional filtering methods, such as state variable filters, particularly in high-bitrate scenarios where the quality factor of analog filters becomes a limiting factor. The proposed system provides a digital solution that can be synthesized for high-frequency operation while maintaining flexibility through its programmable parameters. These and additional details are further discussed below.

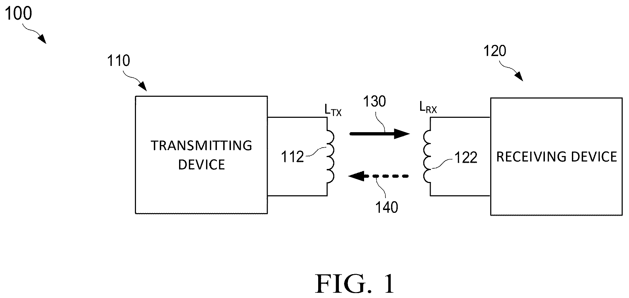

Figure 1 illustrates a block diagram of an embodiment wireless power system 100, which may also be called a wireless charging system. The system includes a transmitting device 110 and a receiving device 120, which may (or may not) be arranged as shown. The transmitting device 110 generates and transmits a power signal 130 to the receiving device 120.

The transmitting device 110 may be a base station, for example, a charging pad, which provides inductive power to the receiving device 120. The receiving device 120 may be, for example, a mobile device, a tablet, a cellular phone, a wearable communications device (e.g., a smartwatch), a digital pen, a wireless headphone, a toothbrush, a sensor, internet of things (IoT) device, or the like. The receiving device 120 is the consumer of inductive power.

The transmitting device 110 includes a transmitter coil 112 ($L_{TX}$). The receiving device 120 includes receiver coil 122 ($L_{RX}$). Each coil, or winding, can be a loop or magnetic antenna. The coils may have a physical core (e.g., ferrite core) or an air core. The coils may be implemented as an antenna strip or using a Litz wire. The resonant frequency of each coil is based on the shape and size of the looping wire or coil. In some embodiments, additional capacitance and inductance may be added to each coil to create a resonant structure at the desired resonant operating frequency.

In embodiments, the power signal 130 is transmitted from the transmitting device 110 to the receiving device 120 using resonant inductive coupling between the transmitter coil 112 and the receiver coil 122. The receiving device 120 may use the power to charge rechargeable batteries or power the components within it directly. In embodiments, wireless power system 100 employs frequency-shift keying (FSK) modulation for bidirectional communication between the transmitting device 110 and the receiving device 120. The transmitting device 110 can modulate the frequency of its power signal 130 to encode data, which is then demodulated by the receiving device 120. Conversely, the receiving device 120 can communicate back to the transmitting device 110 using ASK-modulated signal 140. The bidirectional ASK/FSK communication allows for exchanging information, such as power transfer protocols, device identification, and charging status.

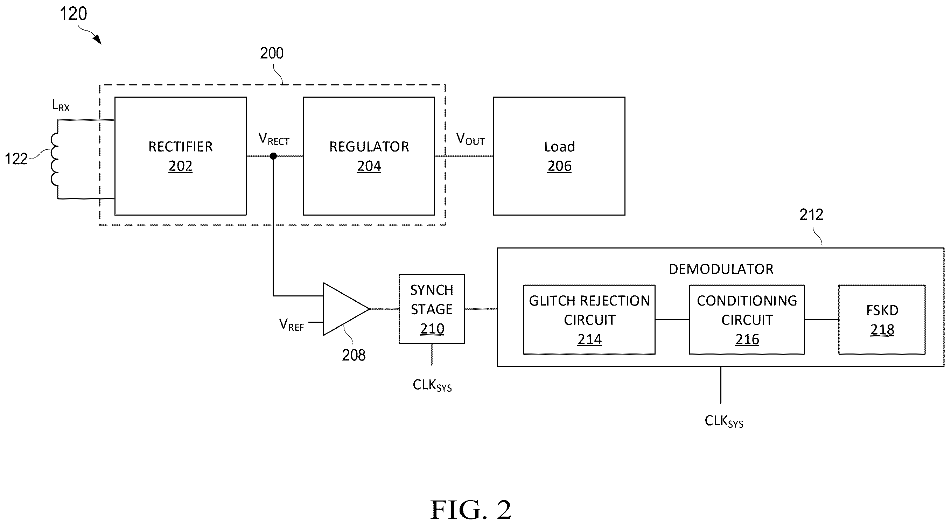

The receiving device 120 incorporates a glitch rejection circuit within its FSK demodulator to ensure accurate demodulation and decoding of the power signal 130, even in the presence of noise and distortions that may arise from the power transfer process. The glitch rejection technique enables reliable high-bitrate communication, which can be particularly beneficial for optimizing power transfer efficiency and supporting advanced features in compact electronic devices. Figure 2 illustrates a block diagram of an embodiment receiving device 120. The receiving device 120 includes the receiver coils 122, a power charging circuit 200, a load 206, a comparator 208, a synchronization stage 210, and a demodulator 212, which may (or may not) be arranged as shown. The power charging circuit 200 includes a rectifier 202 and a regulator 204. The receiving device 120 may include additional components not depicted in Figure 2, such as long-term storage (e.g., non-volatile memory, etc.), a non-transitory computer-readable medium, one or more antenna elements, drivers, demodulators, modulators, filter circuits, and impedance matching circuits.

The rectifier 202 converts the alternating current (AC) voltage at the receiver coils 122 to a direct current (DC) voltage. It may be any type of rectifier, such as a low-impedance synchronous rectifier having full-wave or half-wave rectification or an active rectifier. In embodiments, the rectifier 202 may be a bridge rectifier; however, other types of rectifiers are also contemplated.

The regulator 204 receives a voltage ($V_{RECT}$) from the rectifier 202 and then regulates that voltage to maintain a constant output voltage ($V_{OUT}$) at load 206. The regulator 204 may be any type of voltage regulator, such as a linear regulator (e.g., low drop-out (LDO) linear regulator). In some embodiments, the rectifier 202 and the regulator 204 may be part of a switched-mode power supply (SMPS) circuit. As shown, load 206 is the primary benefactor of the transferred wireless energy from the transmitting device 110 to the receiving device 120. The load 206 may be a charge storage device, such as a battery. For example, load 206 may be a cellular phone battery or a smartwatch. For example, the transmitting device 110 may be a charging pad and a smartwatch may be placed on the charging pad. The charging pad transfers wireless power to the smartwatch's battery without connecting cables between the two devices.

Several interface standards have been developed to standardize wireless power transfer and related functions. One such interface standard is Qi, which the Wireless Power Consortium (WPC) promotes. Qi and similar standardized protocols may be used to define the communication interface for controlling the power transfer in the wireless power system 100. For example, the receiving device 120 may request a change (e.g., an increase, a decrease, a pause, etc.) related to the transferred wireless energy from the transmitting device 110.

The mechanism of inductive power transfer can also be utilized for communication between the transmitting device 110 and the receiving device 120. For instance, the receiving device 120 can inform the transmitting device 110 when the charging process is complete. This communication can be facilitated through a technique known as backscatter modulation, as specified in the Qi Standard for inductive wireless power transfer.

In practice, the receiving device 120 can alter its load impedance by, for example, changing the impedance of the load 206. The change in the impedance results in observable variations in the amplitude of the current or voltage in the transmitter coil 112, allowing for transmitting information from the receiving device 120 to the transmitting device 110.

The comparator 208 is configured to compare the rectified voltage from the rectifier 202 with a reference voltage ($V_{REF}$). The comparison generates a digital signal representing the frequency variations in the incoming power signal, effectively converting the analog FSK-modulated signal into a digital form suitable for further processing.

The synchronization stage 210 is configured to align the incoming signal from the comparator 208 with the system clock ($CLK_{SYS}$), ensuring proper timing for the subsequent demodulation process. The synchronization stage 210 may include circuitry to detect and correct phase differences between the incoming signal and the system clock. This can be advantageous for accurate frequency measurement in the counter-based FSK demodulation approach.

The demodulator 212 includes a glitch rejection circuit 214, a conditioning circuit 216, and a demodulating circuit 218, which may (or may not) be arranged as shown. Demodulator 212 may include additional components not shown, such as filtering stages.

Glitch rejection circuit 214 can be arranged as a normalized low-pass filter. It is configured to filter out glitches from a binary input signal, producing a clean output signal and overcoming the limitations of existing solutions.

In various embodiments, the conditioning circuit 216 is configured to process the output from the glitch rejection circuit 214, which receives signals from an internal hysteresis comparator. The conditioning circuit 216 can provide multiple operational modes to further enhance signal quality. In an embodiment, the conditioning circuit 216 can be bypassed, effectively bypassing any additional processing. In another embodiment, the conditioning circuit 216 functions as a blanking circuit or deglitcher, activated by a glitch rejection signal.

The blanking operation provided by the conditioning circuit 216 can implement a temporal masking mechanism based on predictable glitch behavior patterns in the input signal-received from the glitch rejection circuit 214.

For example, these patterns include a characteristic sequence at the duty cycle's start, comprising a low-to-high transition followed by a voltage dip before stabilizing at the duty level. As another example, at the duty cycle's end, a high-to-low transition is followed by a spurious pulse.

In various embodiments, the blanking operation employs a counter-based approach to address known patterns. Upon detecting a signal transition edge, either ascending or descending, the conditioning circuit 216 updates its output and initiates a counter. During the counting period, the output remains masked until the counter reaches a predetermined maximum value. This temporal masking can effectively filter out predictable spurious signals that follow legitimate transitions. The upstream glitch rejection can help prevent false triggering of the blanking mechanism by filtering out random glitches before they reach the blanking stage. In another embodiment, the conditioning circuit 216 can be configured as a bandpass filter with a low quality factor, providing an alternative method of signal conditioning. The flexibility in configuration allows for optimization based on specific signal characteristics and application requirements.

The demodulating circuit 218 implements the counter-based FSK demodulation technique. In embodiments, it uses the synchronized signal from the synchronization stage 210 and the system clock to measure the frequency of the incoming FSK signal. The demodulating circuit 218 can count the number of system clock cycles within each period of the FSK signal, converting the frequency variations into digital values representing the transmitted data.

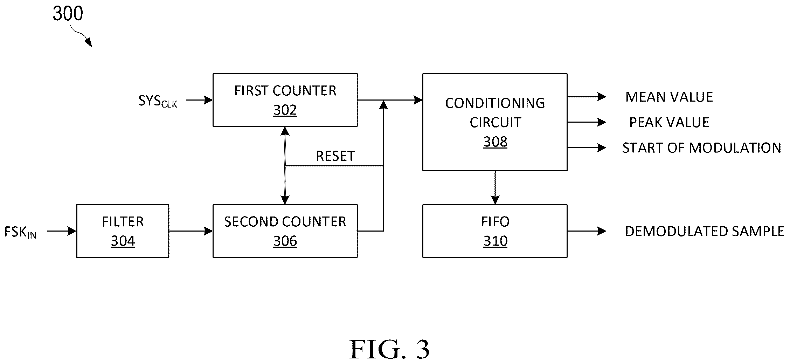

Figure 3 illustrates a block diagram of an embodiment circuit 300, which can be implemented within the demodulator 212. Circuit 300 includes a first counter 302, a filter 304, a second counter 306, a conditioning circuit 308, and a first-in-first-out (FIFO) logic circuit 310. These components may or may not be arranged as shown, and circuit 300 may include additional components not depicted in the figure.

Circuit 300 is designed to measure the frequency of an unknown signal (e.g., $FSK_{IN}$) based on a known frequency signal (e.g., $SYS_{CLK}$). This approach forms the basis of counter-based FSK demodulation, where the number of system clock ticks within one period of the incoming FSK signal determines the FSK signal's frequency. This count is approximately equal to the ratio of the system clock frequency to the FSK signal frequency ($\frac{\bar{SYS_{CLK}}}{FSK_{IN}}$).

The first counter 302 receives the system clock signal ($SYS_{CLK}$) and increments its value at each rising edge of this known frequency signal. Concurrently, the filter 304 receives the incoming FSK signal ($FSK_{IN}$) and clears potential glitches, effectively acting as a bandpass filter. The second counter 306, coupled to the filter's output, increments its value at each rising edge of the filtered FSK signal. The operation of these counters is synchronized such that the first counter 302 increments until the second counter 306 registers a single increment. This event triggers a reset of both counters, preparing them for the next evaluation cycle. This mechanism allows the conversion of the unknown frequency signal into digital samples, with the value in the first counter 302 corresponding to the frequency of the incoming FSK signal.

Typically, the evaluation occurs over multiple carrier cycles to address the challenge of distinguishing between closely spaced FSK frequencies. This approach involves accumulating counts over several periods (N increments of the second counter 306), enhancing the system's ability to differentiate between small frequency differences, even in the presence of noise or signal distortions.

For example, consider a system with a 48 MHz system clock frequency and two FSK signal frequencies: 127.772 kHz ($FSK_{IN1}$) and 126.984 kHz ($FSK_{IN2}$). In this case, the first FSK signal ($FSK_{IN1}$) would result in approximately $376 \pm 1$

clock ticks per period, while the second FSK signal ($FSK_{IN2}$) would result in approximately 378 $\pm$ 1 clock ticks per period.

As demonstrated in this example, the frequencies of the incoming FSK signals can be very close, resulting in a small difference in the number of clock ticks counted. In an extreme case, both signals might result in a count of 377 ticks, making it impossible to distinguish between them in a single period. This small difference poses a challenge for reliable frequency change detection, particularly in the presence of noise or signal distortions.

The conditioning circuit 308 further processes the digital samples by averaging, extracting a baseline measurement (mean value), a peak measurement (peak value), and detecting the start of modulation. The FIFO logic circuit 310 stores the demodulated samples for subsequent processing or analysis.

This design allows for robust FSK demodulation, accurately distinguishing between closely spaced frequencies and operating effectively even in challenging signal conditions typical in wireless power transfer applications.

However, the conventional FSK demodulation process faces challenges. The rectified voltage often contains glitches (i.e., unwanted short-duration pulses or transitions) that can occur near the boundaries of frequency transitions and result from various factors such as component selection, coil coupling, and load characteristics. These glitches can lead to errors in the frequency measurement process, potentially causing misinterpretation of the transmitted data.

Existing solutions to address the glitch at the rectified voltage have various limitations. One approach involves using a bandpass filter (BPF) in the input chain, such as a state variable filter. While effective in reducing glitches, the conventional method struggles at high bitrates. The quality factor of the filter cannot be set too high without risking cutting off the modulation itself, especially when dealing with bitrates around 120 kbps. Additionally, the circuit for such filters can be challenging to synthesize at high frequencies due to long critical paths in their design.

Another conventional solution uses a Reset/Set (RS) flip-flop to generate a clean frequency signal. However, this approach can be problematic when the input signals contain glitches whose number changes over time. In such cases, the flip-flop output can produce large frequency steps that may trigger false modulation detection interrupts, leading to communication errors.

These limitations become increasingly problematic as wireless power transfer systems evolve to support higher data rates and more sophisticated communication protocols, particularly in compact electronic devices where signal integrity is typically challenging to maintain.

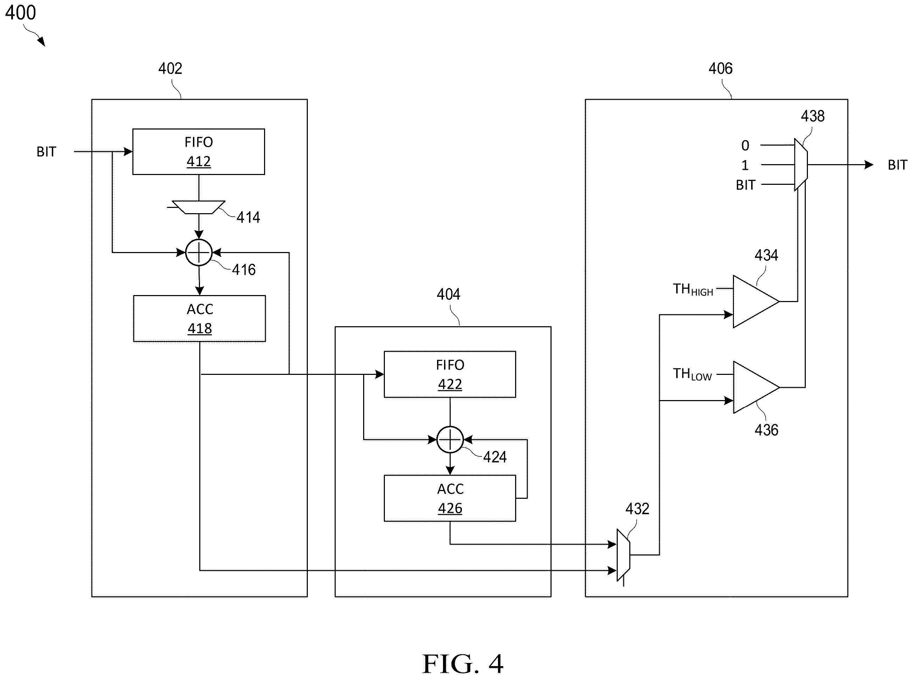

Figure 4 illustrates a block diagram of a glitch rejection circuit 400, which can be implemented within the demodulator 212 as the glitch rejection circuit 214. Glitch rejection circuit 400 includes a first moving average (MA) stage 402, a second MA stage 404, and a hysteresis comparator stage 406, which may (or may not) be arranged as shown. Glitch rejection circuit 400 may include additional components not shown. Glitch rejection circuit 400 is arranged as a normalized low-pass filter. It is configured to filter out glitches from a binary input signal, producing a clean output signal and overcoming the limitations of existing solutions.

The circuit's design incorporates a maximum of four adders in the critical path, resulting in minimal critical path extension. The efficient structure allows the glitch rejection circuit 400 to operate effectively at high frequencies while maintaining low latency. It is particularly suitable for high-bitrate FSK demodulation in wireless power transfer applications.

The first MA stage 402 implements a recursive moving average without division. It consists of a FIFO buffer 412, a multiplexer 414, an adder circuit 416, and an accumulator 418, which may (or may not) be arranged as shown. The first MA stage 402 may include additional components not shown.

The input binary signal, sampled at the system frequency ($F_{SYS}$), is fed into the FIFO buffer 412, which stores the last K input samples. The adder circuit 416 has three inputs: (1) the current input binary sample (NEW_IN_BIT), (2) the output of the multiplexer 414 (MUX_OUT), and (3) the current value stored in the accumulator 418 (CURR_ACC_VAL). The multiplexer 414 selects the bit in the FIFO buffer 412 (the bit being pushed out of the window) at the desired length (moving average length $\leq$ K).

The adder circuit 416 performs the operation: NEW_ACC_VAL = CURR_ACC_VAL + NEW_IN_BIT - MUX_OUT. This operation effectively adds the new input bit (NEW_IN_BIT) to the sum (if it's a '1'), subtracts the oldest bit in the window (if it was a '1'), and maintains the current sum otherwise. The result is stored back in the accumulator 418. This mechanism ensures that the accumulator 418 always contains the count of '1's in the current moving average length window, implementing a moving sum over the window without requiring a full recalculation at each step.

The output of the accumulator 418 has a peak value that depends on the relationship between the duty cycle of the input binary signal and the moving average length of the first MA stage 402. If the moving average length is greater than the length of the duty cycle, the peak value equals the length of the duty cycle. Conversely, if the moving average length is less than the length of the duty cycle, the peak value equals the moving average length. This relationship sets the peak value equal to the minimum of the moving average length (*MA_LENGTH*) and the length of the duty cycle (*DUTY_LENGTH*) (i.e., *PEAK = MIN(MA_LENGTH, DUTY_LENGTH)*).

The sizing of the FIFO buffer 412 determines the glitch rejection capabilities of the glitch rejection circuit 400. The maximum FIFO dimension (i.e., K points) is related to the maximum glitch width that can be effectively rejected.

For example, in a system operating at a system frequency ($F_{SYS}$) of 288 MHz with a maximum FIFO dimension of 128 points, the glitch rejection circuit 400 can reject glitches up to 0.22 microseconds ($\mu$s) in width (i.e.,

$Maximum\ Rejectable\ Glitch\ Width = \frac{K}{2} \times \frac{1}{F_{SYS}}$ ). It's important to note that while this calculation provides a theoretical maximum, the actual glitch widths encountered in a real system may vary depending on external components and coupling conditions. Therefore, the size of the FIFO buffer 412 should be chosen with consideration of the specific application and expected signal characteristics. The second MA stage 404 is an n-point moving average (n being an integer), where in an embodiment, n equals three. This stage is designed to smooth the output from the first MA stage 402, helping to prevent multiple threshold crossings that could lead to erroneous output. The second MA stage 404 includes a FIFO buffer 422, an adder circuit 424, and an accumulator circuit 426, which may (or may not) be arranged as shown. The second MA stage 404 may include additional components not shown.

The n-word FIFO buffer 422 stores the n-number of previous outputs from the first MA stage 402. In embodiments, the FIFO buffer 422 is a 3-word FIFO buffer, which stores the three previous outputs from the first MA stage 402. This allows the second MA stage 404 to maintain a "memory" of recent values for the moving average calculation.

The inputs to the adder circuit 424 are the outputs from the n-word FIFO buffer 422, the current output from the first MA stage 402, and the current output from the accumulator circuit 426. The adder circuit 424 effectively updates the sum of the last three points by adding the new value and subtracting the oldest value. The output of the adder circuit 424 is passed to the accumulator circuit 426. The output of the accumulator circuit 426 is fed back to the adder circuit 424, creating a recursive structure. This feedback loop allows the circuit to maintain a running average without explicitly storing all previous values.

Implementing an n-point moving average provides continuous smoothing of the signal, effectively reducing short-term fluctuations while maintaining responsiveness to genuine signal changes. The recursive nature of the circuit allows for efficient computation and seamless processing of the continuous input stream. In embodiments, the 3-point moving average provides a good balance between additional smoothing and maintaining responsiveness to genuine signal changes. It helps to reduce the likelihood of false detections due to noise or short-duration glitches while allowing the glitch rejection circuit 400 to respond quickly to actual changes in the input signal.

The hysteresis comparator stage 406 includes a first multiplexer 432, a first comparator 434, a second comparator 436, and a second multiplexer 438, which may (or may not) be arranged as shown.

The outputs of the first MA stage 402 and the second MA stage 404 are fed as inputs to the first multiplexer 432. The first multiplexer 432 can forward one of the outputs to the first comparator 434 and the second comparator 436, effectively implementing a bypass or enable mode selection for the second MA stage 404. For example, the second MA stage 404 can be bypassed when the first multiplexer forwards the output of the first MA stage 402. As another example, the second MA stage 404 can be enabled when the first multiplexer forwards the output of the second MA stage 404. This multi-mode operation provides flexibility in operation. The output of the first multiplexer 432 is fed as inputs to the first comparator 434 and the second comparator 436. The first comparator 434 compares the output of the first multiplexer 432 with a first threshold (e.g., $TH_{HIGH}$). In an embodiment, if the output of the first multiplexer 432 is greater than or equal the first threshold, the output of the first comparator 434 is a logic '1'; otherwise, the output is a logic '0'.

In contrast, the second comparator 436 compares the output of the first multiplexer with a second threshold (e.g., $TH_{LOW}$). In an embodiment, if the output of the first multiplexer 432 is less than the second threshold, the output of the second comparator 436 is a logic '1'; otherwise, the output is a logic '0'.

In embodiments where the second MA stage 404 is not bypassed, the first and second thresholds are programmable and can be set based on the peak value determined in the previous stages. Accordingly, the effective threshold for the first threshold can be calculated as: $TH_{HIGH} = 3 \times (1 - \alpha) \times PEAK$, where $\alpha$ can be set to a value between 0 and 0.5 (i.e., $\alpha \in ]0,0.5[$) and PEAK equals the minimum of the moving average length (MA_LENGTH) and the length of the duty cycle (DUTY_LENGTH). In an embodiment, the effective threshold for the second threshold can be calculated as: $TH_{LOW} = 3 \times \alpha \times PEAK$.

In embodiments, where the second MA stage is bypassed, the effective threshold for the first threshold can be calculated as $TH_{HIGH} = (1 - \alpha) \times PEAK$ and the effective threshold for the second threshold can be calculated as: $TH_{LOW} = \alpha \times PEAK$.

The circuit also allows for adjusting the confidence level based on the input signal's duty cycle. For example, using a lower confidence level (i.e., higher alpha) with a higher duty cycle is possible. A higher $\alpha$ value brings the first and second thresholds closer together, making the glitch rejection circuit 400 more sensitive to changes in the input signal.

Further, with a higher duty cycle, the signal pulses are wider and more distinct from short glitches. Accordingly, the glitch rejection circuit 400 can more readily distinguish between legitimate signal changes and unwanted glitches. This allows the glitch rejection circuit 400 to be more responsive to actual signal changes when dealing with input signals with a higher proportion of ON time (i.e., higher duty cycle) while maintaining effective glitch rejection. This represents a tradeoff between sensitivity to real signal changes and robustness against noise or glitches, which can be optimized based on the characteristics of the input signal.

The sampling clock frequency can also affect the glitch rejection capabilities of the glitch rejection circuit 400. A higher sampling clock frequency can provide higher resolution and more samples for glitch detection and rejection.

Increasing the sampling frequency while maintaining the same duty cycle can yield additional samples for signal analysis, similar to the effect of increasing the duty cycle at a fixed sampling frequency. The relationship between sampling frequency and number of samples can provide additional flexibility in optimizing the glitch rejection performance.

The second multiplexer 438 determines the final output of the glitch rejection circuit 400. It has three input signals: a logic '1', a logic '0', and the previous output bit (BIT). The output of the first comparator 434 and the second comparator 436 provide the selection signal for the second multiplexer 438. Accordingly, the selection of which input to forward as the output of the second multiplexer 438 is based on the outputs of the first comparator 434 and the second comparator 436. When the input signal (from the first multiplexer 432) is greater than or equal to the first threshold ($TH_{HIGH}$), the second multiplexer 438 selects the logic '1' input. When the input signal is less than the second threshold ($TH_{LOW}$), it selects the logic '0' input. In the region between these thresholds, known as the hysteresis band, the second multiplexer 438 maintains the previous output state by selecting the BIT output.

This operation creates a hysteresis effect, preventing rapid toggling of the output due to small fluctuations in the input signal around a single threshold. The hysteresis behavior enhances noise immunity and stability when the input signal may contain residual glitches or noise that passes through the earlier filtering stages.

Advantageously, the glitch rejection circuit 400 provides a robust method for cleaning binary input signals. Utilizing multiple stages of moving averages and a programmable hysteresis comparator can effectively remove glitches while maintaining the integrity of the original signal, even in high-frequency applications typical in wireless power transfer systems.

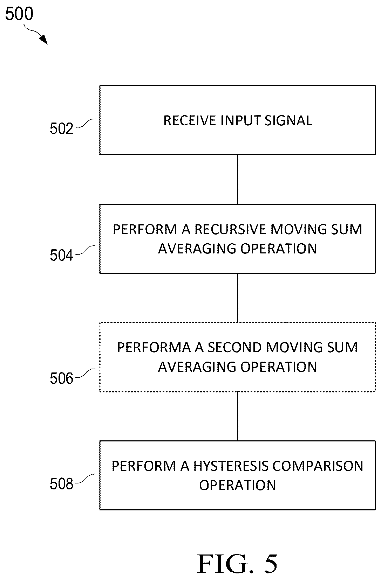

Figure 5 illustrates a flowchart of an embodiment method 500 for glitch rejection in FSK demodulation. Method 500 may be implemented in a wireless power transfer system, such as the wireless power system 100. It is noted that all steps outlined in the flow chart of method 500 are not necessarily required and can be optional. Further, changes to the arrangement of the steps, removal of one or more steps and path connections, and addition of steps and path connections are similarly contemplated.

At step 502, a binary input signal sampled at the system frequency is received. This input signal may contain glitches or unwanted short-duration pulses that are to be filtered out. These glitches can occur due to various factors, such as component selection, coil coupling variations, load characteristics, and electromagnetic interference. For example, sudden changes in the load or coupling between the transmitter and receiver coils can induce voltage spikes or brief oscillations in the rectified signal. Additionally, the switching nature of power conversion circuits can introduce high-frequency noise.

These glitches pose challenges to accurate FSK demodulation, particularly at high bitrates. If not removed, glitches can lead to false triggering of the demodulator's counter, resulting in erroneous frequency measurements and incorrect data interpretation. This can be especially problematic in compact electronic devices where signal integrity is inherently difficult to maintain due to space constraints and the proximity of various components. Therefore, effective glitch removal ensures reliable communication and optimal performance in wireless power transfer systems. This enables accurate data exchange for power transfer protocols, device identification, and charging status updates.

At step 504, the signal is processed through a first moving average (MA) stage. This step involves storing the K most recent samples in a FIFO buffer, adding the new input bit to an accumulator, subtracting the oldest bit from the accumulator, and outputting the current accumulator value. The length K of this moving average can be programmable, allowing for adjustment based on the maximum glitch width to be rejected.

Step 506 represents the optional second MA stage. If enabled, this step processes the output from the first MA stage through an n-point (e.g., 3 point) moving average. The three most recent outputs from the first MA stage are stored, the average is calculated, and the output is a smoothed signal. The additional averaging can help prevent multiple threshold crossings leading to erroneous output.

At step 508, the signal is passed through a hysteresis comparator. This step involves comparing the signal to the high and low thresholds. The output is determined based on these comparisons: if the signal is greater than or equal to the high threshold, the output is set to logic '1'; if the signal is less than the low threshold, the output is set to logic '0'; if the signal falls between the two thresholds, the previous output state is maintained. Having been processed through the moving average stages and hysteresis comparator, the output signal is free of the short-duration glitches in the original input. The glitch-free clock signal can be fed to an FSK demodulator counter.

The clean signal allows accurate frequency measurement in the counter-based FSK demodulation, even at high bitrates and system clock frequencies. Method 500 provides a robust approach to glitch rejection, leveraging the programmable moving average stages and hysteresis comparator to effectively remove unwanted signal artifacts while preserving the integrity of the FSK-modulated data.

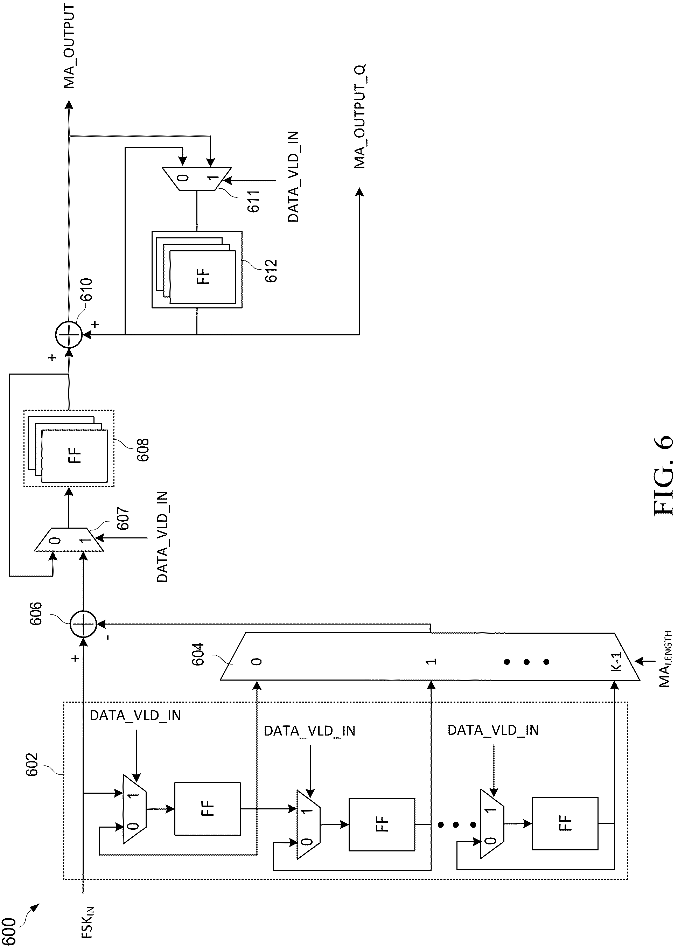

Figure 6 illustrates a block diagram of an embodiment first moving average (MA) stage 600, which shares functional similarities with the first MA stage 402 described in Figure 4. The first MA stage 600 implements a recursive moving sum average. It includes a chain of flip-flops and multiplexers 602, a first multiplexer 604, a first adder circuit 606, a second multiplexer 607, an optional register 608, a second adder circuit 610, a third multiplexer 611, and an output register 612, which may (or may not) be arranged as shown. This implementation maintains the functionality described for the first MA stage 402 while optimizing the timing by strategically placing pipeline registers.

The input data signal ($FSK_{IN}$) is fed into the chain of flip-flops and multiplexers 602 that form a shift register. Each flip-flop stores one bit, with the chain extending along K flip-flops, effectively implementing the FIFO buffer functionality-K corresponding to the buffer size. The length of this chain is configurable. This configuration allows for flexible adjustment of the moving average window based on the maximum glitch width to be rejected. Each multiplexer within the chain of flip-flops and multiplexer 602 includes a select input coupled to an enable signal (DATA_VLD_IN). The enable signal, when asserted, enables the start/shifting inside the FIFO buffer.

The first multiplexer 604, with K number of inputs, receives the outputs from all flip-flops in the chain of flip-flops and multiplexers 602. The first multiplexer 604 selects the appropriate delayed version of the input signal based on the programmed moving average (MA) length value, effectively implementing the selection of the oldest bit in the moving average window. This operation is similar to the multiplexer 414 in Figure 4, though implemented with additional flexibility through the programmable length selection.

The first MA stage 600 includes two adder stages. The first adder circuit 606 and the second adder circuit 610 implement the recursive moving sum average operation, adding the new input bit while subtracting the oldest bit from the current sum. The optional register608 is arranged between the adders to break the critical path and facilitate easier synthesis at higher operating frequencies.

The output of the output register 612 provides the moving average result to subsequent processing stages. The second multiplexer 607 and the third multiplexer 611, which can be removed in some embodiments, can be employed to enable or disable the capturing process by setting the enable signal, as previously discussed.

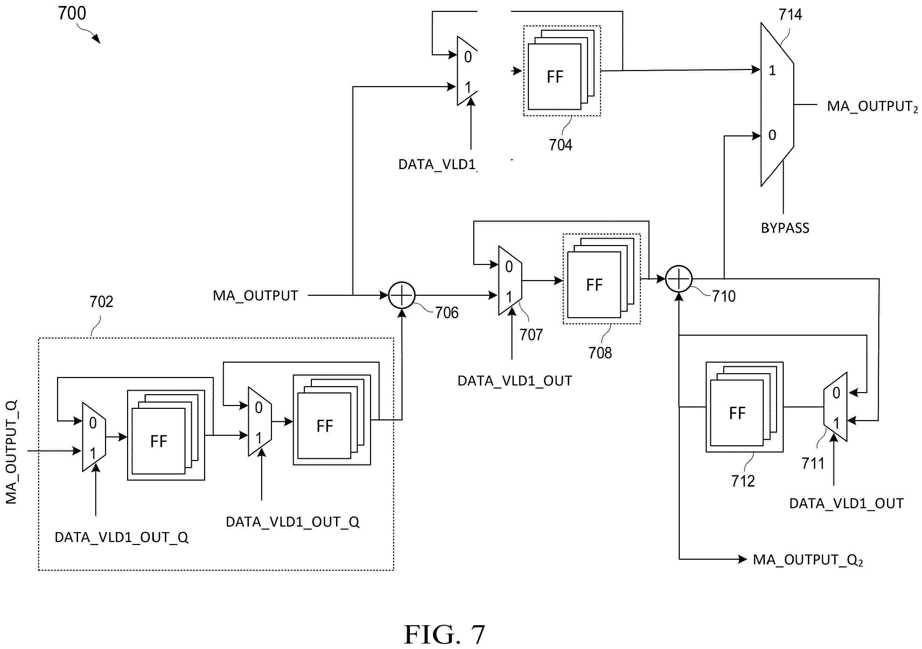

Figure 7 illustrates a block diagram of an embodiment second moving average (MA) stage 700, which shares functional similarities with the second MA stage 404 described in Figure 4. The second MA stage 700 implements a three-point moving average and includes a series of registers and multiplexers 702, a first multiplexer 703, a first optional register 704, a first adder circuit 706, a second multiplexer 707, a second optional register 708, a second adder circuit 710, a third multiplexer 711, an output register 712, and a bypass multiplexer 714, which may (or may not) be arranged as shown. This implementation maintains the core functionality of the second MA stage 404 while incorporating additional features for improved timing performance and operational flexibility. The strategic placement of pipeline registers and the inclusion of bypass functionality make this design particularly suitable for high-frequency applications in FSK demodulation systems.

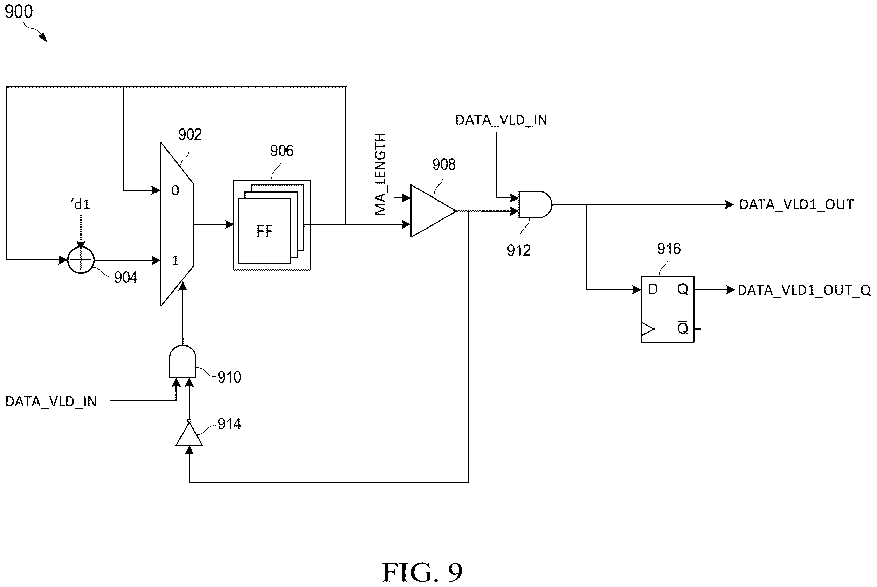

The input signal from the first MA stage 402 passes through the series of registers and multiplexers 702 that store consecutive samples for the three-point average calculation. In embodiments, the series of registers and multiplexers 702 includes two registers. The output of these samples is fed into the first adder circuit 706. The select inputs of the multiplexers in the series of registers and multiplexers 702 receives a synchronization signal (DATA_VLD_OUT_Q) to synchronize the operation of the first MA stage 402 with the operation of the second MA stage 404-further detailed in Figure 9.

The first adder circuit 706 and the second adder circuit 710 perform the summation of three consecutive points, implementing the three-point moving average computation described in the second MA stage 404.

The first optional register 704 and the second optional register 708 (arranged between the adder stages) break the critical path. This pipelining technique facilitates easier synthesis at higher operating frequencies while maintaining the functional requirements of the moving average operation. Adding the optional registers provides flexibility in meeting timing constraints without affecting the fundamental averaging operation.

The output stage includes a bypass multiplexer 714 controlled by a bypass signal. The bypass multiplexer 714 allows the circuit to forward the three-point averaged output or bypass the averaging operation entirely. The bypass capability provides operational flexibility, allowing the system to adapt to different signal conditions or testing requirements. The final output is provided at the output register 712. The first multiplexer 703, the second multiplexer 707, and the third multiplexer 711, which can be removed in some embodiments, can be employed to enable or disable the capturing process by setting the synchronization signal (DATA_VLD1_OUT), as previously discussed.

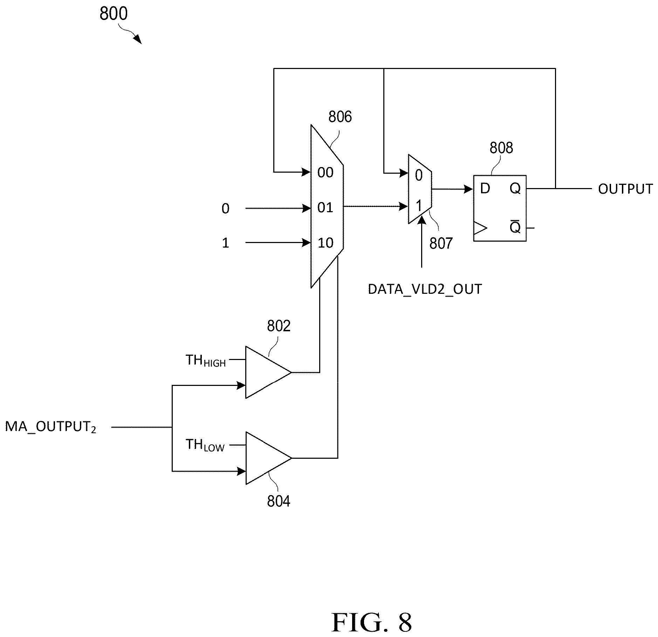

Figure 8 illustrates a block diagram of an embodiment hysteresis comparator stage 800, which shares functional similarities with the hysteresis comparator stage 406 described in Figure 4. The hysteresis comparator stage 800 includes a first comparator 802, a second comparator 804, a first multiplexer 806, a second multiplexer 807, and a flip-flop 808, which may (or may not) be arranged as shown. This configuration maintains consistency with the functionality described in the hysteresis comparator stage 406.

The first comparator 802 and second comparator 804 receive an input signal ($MA\_OUTPUT_2$) from the second MA stage 404 and compare it with high and low thresholds, respectively. The first comparator 802 compares the input signal with a first threshold ($TH_{HIGH}$). In an embodiment, if the input signal is greater than or equal to the first threshold, the output of the first comparator 802 is a logic '1'; otherwise, the output is a logic '0'. The second comparator 804 compares the input signal with a second threshold ($TH_{LOW}$). In an embodiment, if the input signal is less than the second threshold, the output of the second comparator 804 is a logic '1'; otherwise, the output is a logic '0'.

The first multiplexer 806 determines an intermediate output based on the comparison results. It has three input signals: a logic '1', a logic '0', and the previous output (OUTPUT). The outputs of the first comparator 802 and the second comparator 804 provide the selection signals for the first multiplexer 806. When the input signal is greater than or equal to the first threshold, the first multiplexer 806 selects the logic '1' input. When the input signal is less than the second threshold, it selects the logic '0' input. In the region between these thresholds, known as the hysteresis band, the first multiplexer 806 maintains the previous output state by selecting the previous output.

The flip-flop 808 is coupled to the output of the first multiplexer 806 and is clocked by a system clock signal. The flip-flop 808 synchronizes the output with the system clock, providing a clean, glitch-free output signal. This synchronization ensures proper timing for subsequent processing stages in the FSK demodulator.

The second multiplexer 807, which can be removed in some embodiments, can be employed to enable or disable the capturing process by properly setting the enable signal (DATA_VLD2_OUT).

While not shown in Figure 8, it is understood that a bypass multiplexer, similar to the first multiplexer 432 in Figure 4, can be added at the input stage to provide the flexibility of bypassing or enabling the second MA stage.

Figure 9 illustrates a block diagram of a first synchronization circuit 900, which provides synchronization between the first moving average stage and the second moving average stage of the glitch rejection circuit 400. The first synchronization circuit 900 includes a multiplexer 902, an adder circuit 904, a register 906, a comparator 908, a first AND gate 910, a second AND gate 912, an inverter 914, and an output flip-flop 916, which may (or may not) be arranged as shown.

The first synchronization circuit 900 includes a feedback loop where the adder circuit 904 receives two inputs: a constant value 'd1 and a feedback signal. The adder's output feeds into the multiplexer 902, a 2-to-1 multiplexer, that selects between the feedback and the adder output based on the moving average length control signal. The multiplexer's output is registered by the register 906, which provides the feedback signal back to the adder circuit 904.

The comparator 908 compares the moving average length value with the output of the register 906. The output of the comparator 908 feeds into the second AND gate 912 directly and into the first AND gate 910 through the inverter 914. The first AND gate 910 performs a logical AND operation between the inverted comparator output and the enable signal (DATA_VLD_IN). The second AND gate 912 performs a logical AND operation between the direct comparator output and the enable signal.

The outputs of the AND gates form the synchronized output (DATA_VLD1_OUT). This output is further registered by the output flip-flop 916 to produce a clean, synchronized signal (DATA_VLD1_OUT_Q). The synchronized signal (DATA_VLD1_OUT_Q) serves as a synchronization signal that coordinates the operation between the first and second moving average stages.

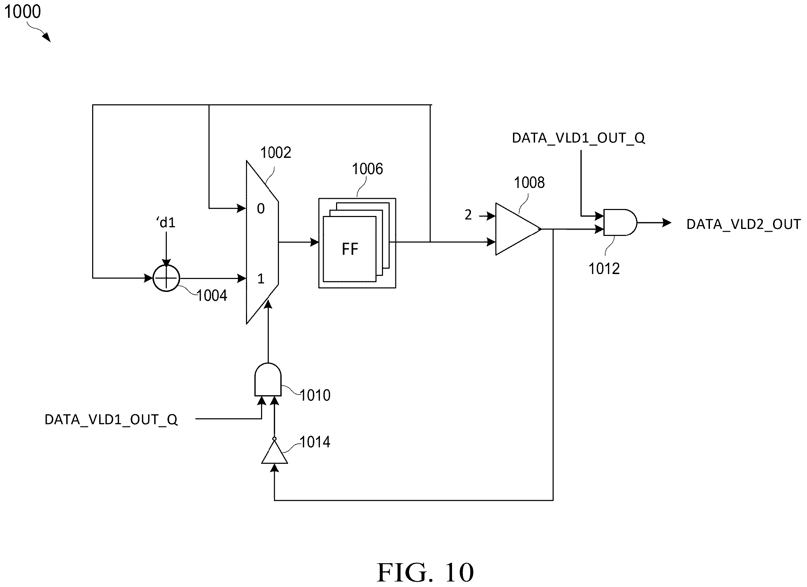

Figure 10 illustrates a block diagram of a second synchronization circuit 1000, which provides synchronization between the second moving average stage and the hysteresis comparator stage of the glitch rejection circuit 400. The second synchronization circuit 1000 includes a multiplexer 1002, an adder circuit 1004, a register 1006, a comparator 1008, a first AND gate 1010, a second AND gate 1012, and an inverter 1014, which may (or may not) be arranged as shown.

The second synchronization circuit 1000 includes a feedback loop where the adder circuit 1004 receives two inputs: a constant value 'd1 and a feedback signal. The adder's output feeds into the multiplexer 1002, a 2-to-1 multiplexer, that selects between the feedback and the adder output based on the moving average length control signal. The multiplexer's output is registered by the register 1006, which provides the feedback signal back to the adder circuit 1004.

The comparator 1008 compares the output of the register 1006 with the value of two (2). The output of the comparator 1008 feeds into the second AND gate 1012 directly and into the first AND gate 1010 through the inverter 1014. The first AND gate 1010 performs a logical AND operation between the inverted comparator output and the enable signal (DATA_VLD1_OUT_Q) from the first synchronization circuit 900. The second AND gate 1012 performs a logical AND operation between the direct comparator output and the enable signal (DATA_VLD1_OUT_Q).

The outputs of the AND gates form the synchronized output (DATA_VLD2_OUT), which serves as a synchronization signal that coordinates the operation between the second moving average stage and the hysteresis comparator stage of the glitch rejection circuit.

The synchronization mechanism is particularly advantageous for maintaining proper data flow and preventing timing misalignments between processing stages. The dual AND gate structure with the comparator feedback provides precise control over the synchronization timing based on the programmed moving average length value. By providing a synchronized control signal, the circuit ensures that data is properly captured and processed as it moves from one stage to the next, contributing to the overall reliability of the glitch rejection process.

A first aspect relates to a circuit for glitch rejection in a frequency-shift keying (FSK) demodulator, the circuit configured to receive a binary input signal sampled at a system frequency, the circuit comprising a first stage averaging circuit with a programmable length; a second stage averaging circuit coupled to an output of the first stage averaging circuit; and a hysteresis comparator coupled to an output of the second stage averaging circuit, wherein the circuit is configured to output a glitch-free clock signal.

In a first implementation form of the circuit, according to the first aspect as such, the first stage averaging circuit comprises a first-in-first-out (FIFO) buffer configured to store input samples; a multiplexer configured to output the oldest bit from the FIFO buffer; an accumulator configured to maintain a sum of logic ones in the input samples; and an adder circuit configured to update the accumulator by adding new input bits and subtracting the output of the multiplexer, a divider circuit configured to divide an output of the accumulator by the programmable length, or a combination thereof.

In a second implementation form of the circuit, according to the first aspect as such or any preceding implementation form of the first aspect, the second stage averaging circuit is a three-point moving average circuit.

In a third implementation form of the circuit, according to the first aspect as such or any preceding implementation form of the first aspect, the hysteresis comparator comprises a programmable high threshold and a programmable low threshold.

In a fourth implementation form of the circuit, according to the first aspect as such or any preceding implementation form of the first aspect, the programmable high threshold and the programmable low threshold are set based on a peak value of the output of the first stage averaging circuit.

In a fifth implementation form of the circuit, according to the first aspect as such or any preceding implementation form of the first aspect, the circuit further comprising a multiplexer configured to bypass the second stage averaging circuit. In a sixth implementation form of the circuit, according to the first aspect as such or any preceding implementation form of the first aspect, the programmable length is determined based on a maximum glitch width to be rejected.

A second aspect relates to a system for high bitrate frequency-shift keying (FSK) demodulation, the system comprising a glitch rejection circuit configured to receive an input signal from a zero-crossing comparator and generate a glitch-free output, the glitch rejection circuit comprising a first stage averaging circuit with a programmable length, a second stage averaging circuit coupled to an output of the first stage averaging circuit, and a hysteresis comparator with programmable high and low thresholds; a conditioning circuit configured to perform a blanking operation, perform a filtering operation, or be bypassed in response to the operational mode of the conditioning circuit; and an FSK demodulator counter circuit configured to receive the glitch-free output from the glitch rejection circuit. In a first implementation form of the system, according to the second aspect as such, the first stage averaging circuit comprises a first-in-first-out (FIFO) buffer configured to store input samples; a multiplexer configured to output a select bit from the FIFO buffer; an accumulator configured to maintain a sum of logic ones in the input samples; and an adder circuit configured to update the accumulator by adding new input bits and subtracting the output of the multiplexer, a divider circuit configured to divide an output of the accumulator by the programmable length, or a combination thereof.

In a second implementation form of the system, according to the second aspect as such or any preceding implementation form of the second aspect, the glitch rejection circuit includes a second stage comprising the moving average circuit, wherein the second stage comprises a three-point averaging circuit.

In a third implementation form of the system, according to the second aspect as such or any preceding implementation form of the second aspect, the programmable high and low thresholds are set based on a peak value of the output of the first stage averaging circuit.

In a fourth implementation form of the system, according to the second aspect as such or any preceding implementation form of the second aspect, the glitch rejection circuit includes a second stage comprising the moving average circuit, the system further comprising a multiplexer configured to bypass the second stage averaging circuit.

In a fifth implementation form of the system, according to the second aspect as such or any preceding implementation form of the second aspect, the programmable length is determined based on a maximum glitch width to be rejected.

In a sixth implementation form of the system, according to the second aspect as such or any preceding implementation form of the second aspect, the FSK demodulator counter circuit is configured to measure a frequency of the glitch-free output using a known system clock frequency.

A third aspect relates to a method for glitch rejection in a frequency-shift keying (FSK) demodulator, the method comprising receiving a binary input signal sampled at a system frequency; processing the binary input signal through a first stage averaging circuit with a programmable length; processing an output of the first stage averaging circuit through a second stage averaging circuit; applying a hysteresis comparator to an output of the second stage averaging circuit; and outputting a glitch-free clock signal for use by a counter in the FSK demodulator. In a first implementation form of the method, according to the third aspect as such, processing the binary input signal through the first stage averaging circuit comprises storing input samples in a first-in-first-out (FIFO) buffer; maintaining a sum of logic ones in the input samples using an accumulator; and updating the accumulator by adding new input bits and subtracting oldest bits from the FIFO buffer, dividing an output of the accumulator by the programmable length, or a combination thereof.

In a second implementation form of the method, according to the third aspect as such or any preceding implementation form of the third aspect, the second stage averaging circuit is a three-point averaging circuit.

In a third implementation form of the method, according to the third aspect as such or any preceding implementation form of the third aspect, applying the hysteresis comparator comprises using programmable high and low thresholds set based on a peak value of the output of the first stage averaging circuit.

In a fourth implementation form of the method, according to the third aspect as such or any preceding implementation form of the third aspect, the method further comprising selectively bypassing the second stage averaging circuit using a multiplexer.

In a fifth implementation form of the method, according to the third aspect as such or any preceding implementation form of the third aspect, the method further comprising determining the programmable length based on a maximum glitch width to be rejected.

Although the description has been described in detail, it should be understood that various changes, substitutions, and alterations may be made without departing from the spirit and scope of this disclosure as defined by the appended claims. The same elements are designated with the same reference numbers in the various figures. Moreover, the scope of the disclosure is not intended to be limited to the particular embodiments described herein, as one of ordinary skill in the art will readily appreciate from this disclosure that processes, machines, manufacture, compositions of matter, means, methods, or steps, presently existing or later to be developed, may perform substantially the same function or achieve substantially the same result as the corresponding embodiments described herein. Accordingly, the appended claims are intended to include within their scope such processes, machines, manufacture, compositions of matter, means, methods, or steps.

The specification and drawings are, accordingly, to be regarded simply as an illustration of the disclosure as defined by the appended claims, and are contemplated to cover any and all modifications, variations, combinations, or equivalents that fall within the scope of the present disclosure.

**Claims**

1. A circuit (214; 400) for glitch rejection in a frequency-shift keying (FSK) demodulator (212), the circuit (214; 400) configured to receive a binary input signal sampled at a system frequency, the circuit (214; 400) comprising:

   a first stage averaging circuit (402; 600) with a programmable length;
   a second stage averaging circuit (404; 700) coupled to an output of the first stage averaging circuit (402; 600); and
   a hysteresis comparator (406; 800) coupled to an output of the second stage averaging circuit (404; 700), wherein the circuit (214; 400) is configured to output a glitch-free clock signal.

2. The circuit (214; 400) of claim 1, wherein the first stage averaging circuit (402; 600) comprises:

   a first-in-first-out (FIFO) buffer (412; 602) configured to store input samples;
   a multiplexer (414; 604) configured to output the oldest bit from the FIFO buffer (412; 602);
   an accumulator (418) configured to maintain a sum of logic ones in the input samples; and
   an adder circuit (416) configured to update the accumulator (418) by adding new input bits and subtracting the output of the multiplexer (414; 604), a divider circuit configured to divide an output of the accumulator (418) by the programmable length, or a combination thereof.

3. The circuit (214; 400) of claim 1, wherein the second stage averaging circuit (404; 700) is a three-point moving average circuit.

4. The circuit (214; 400) of claim 1, wherein the hysteresis comparator (406; 800) comprises a programmable high threshold and a programmable low threshold, in particular the programmable high threshold and the programmable low threshold being set based on a peak value of the output of the first stage averaging circuit (402; 600).

5. The circuit (214; 400) of claim 1, further comprising a multiplexer (432; 714) configured to bypass the second stage averaging circuit (404; 700).

6. The circuit (214; 400) of claim 1, wherein the programmable length is determined based on a maximum glitch width to be rejected.

7. A system for high bitrate frequency-shift keying (FSK) demodulation, the system comprising:

   a glitch rejection circuit (214; 400) configured to receive an input signal from a zero-crossing comparator (208) and generate a glitch-free output, the glitch rejection circuit (214; 400) comprising:

   a first stage averaging circuit (402; 600) with a programmable length,
   a second stage averaging circuit (404; 700) coupled to an output of the first stage averaging circuit (402; 600), and

a hysteresis comparator (406; 800) with programmable high and low thresholds;
a conditioning circuit (216) configured to perform a blanking operation, perform a filtering operation, or be bypassed in response to the operational mode of the conditioning circuit (216); and

an FSK demodulator circuit (218) configured to receive the glitch-free output from the glitch rejection circuit (214; 400).

8. The system of claim 7, wherein the first stage averaging circuit (402; 600) comprises:

a first-in-first-out (FIFO) buffer (412; 602) configured to store input samples;
a multiplexer (414; 604) configured to output a select bit from the FIFO buffer (412; 602);
an accumulator (418) configured to maintain a sum of logic ones in the input samples; and
an adder circuit (416) configured to update the accumulator (418) by adding new input bits and subtracting the output of the multiplexer (414; 604), a divider circuit configured to divide an output of the accumulator (418) by the programmable length, or a combination thereof.

9. The system of claim 7, wherein the second stage averaging circuit (404; 700) comprises a three-point averaging circuit.

10. The system of claim 7, wherein the programmable high and low thresholds are set based on a peak value of the output of the first stage averaging circuit (402; 600).

11. The system of claim 7, further comprising a multiplexer (432; 714) configured to bypass the second stage averaging circuit (404; 700).

12. The system of claim 7, wherein the programmable length is determined based on a maximum glitch width to be rejected.

13. The system of claim 7, wherein the FSK demodulator circuit (218) is configured to measure a frequency of the glitch-free output using a known system clock frequency.

14. A method (500) for glitch rejection in a frequency-shift keying (FSK) demodulator (212), the method (500) comprising:

receiving a binary input signal sampled at a system frequency;
processing the binary input signal through a first stage averaging circuit (402; 600) with a programmable length;
processing an output of the first stage averaging circuit (402; 600) through a second stage averaging circuit (404; 700);
applying a hysteresis comparator (406; 800) to an output of the second stage averaging circuit (404; 700); and
outputting a glitch-free clock signal for use by a counter in the FSK demodulator (212).

15. The method (500) of claim 14, wherein processing the binary input signal through the first stage averaging circuit (402; 600) comprises:

storing input samples in a first-in-first-out (FIFO) buffer (412; 602);
maintaining a sum of logic ones in the input samples using an accumulator (418); and
updating the accumulator (418) by adding new input bits and subtracting oldest bits from the FIFO buffer (412; 602), dividing an output of the accumulator (418) by the programmable length, or a combination thereof.

16. The method (500) of claim 14, wherein the second stage averaging circuit (404; 700) is a three-point averaging circuit.

17. The method (500) of claim 14, wherein applying the hysteresis comparator (406; 800) comprises using programmable high and low thresholds set based on a peak value of the output of the first stage averaging circuit (402; 600).

18. The method (500) of claim 14, further comprising selectively bypassing the second stage averaging circuit (404; 700) using a multiplexer (432; 714).

19. The method (500) of claim 14, further comprising determining the programmable length based on a maximum glitch width to be rejected.

100

110

120

```
+------------------+       L_TX   130   L_RX
|                  |        ⌇    ──────▶  ⌇    +------------------+
|  TRANSMITTING    |   112 ⌇              ⌇ 122 |                  |
|  DEVICE          |        ⌇    ◀ ─ ─ ─  ⌇    | RECEIVING DEVICE |
|                  |              140            |                  |
+------------------+                            +------------------+
```

FIG. 1

FIG. 2

EP 4 753 218 A1

300

| | | | MEAN VALUE |
| SYS$_{CLK}$ → | FIRST COUNTER 302 | → CONDITIONING CIRCUIT 308 | → PEAK VALUE |
| | | | → START OF MODULATION |
| | RESET | | |
| FSK$_{IN}$ → | FILTER 304 | → SECOND COUNTER 306 | |
| | | FIFO 310 → DEMODULATED SAMPLE | |

FIG. 3

FIG. 4

EP 4 753 218 A1

500

502 — RECEIVE INPUT SIGNAL

504 — PERFORM A RECURSIVE MOVING SUM AVERAGING OPERATION

506 — PERFORMA A SECOND MOVING SUM AVERAGING OPERATION

508 — PERFORM A HYSTERESIS COMPARISON OPERATION

FIG. 5

FIG. 6

FIG. 7

FIG. 8

FIG. 9

EP 4 753 218 A1

DATA_VLD2_OUT

DATA_VLD1_OUT_Q

1012

1008

2

1006

FF

1002

0

1

1004

'd1

1010

1014

DATA_VLD1_OUT_Q

1000

FIG. 10

## EUROPEAN SEARCH REPORT

**Application Number**

EP 25 21 6446

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 6 674 812 B1 (STEVENSON CARL R [US]) 6 January 2004 (2004-01-06) * the whole document * | 1-19 | INV. H04L27/14 ADD. H04L27/06 |
| A | US 2019/109740 A1 (SNEDEKER MICHAEL DOUGLAS [US] ET AL) 11 April 2019 (2019-04-11) * the whole document * | 1-19 | H04L27/156 |

**TECHNICAL FIELDS SEARCHED (IPC)**

H04L

The present search report has been drawn up for all claims

| Place of search | Date of completion of the search | Examiner |
|---|---|---|
| The Hague | 25 March 2026 | Skraparlis, D |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 21 6446

This annex lists the patent family members relating to the patent documents cited in the above-mentioned European search report.
The members are as contained in the European Patent Office EDP file on
The European Patent Office is in no way liable for these particulars which are merely given for the purpose of information.

25-03-2026

| Patent document cited in search report | | Publication date | Patent family member(s) | Publication date |
|---|---|---|---|---|
| US 6674812 | B1 | 06-01-2004 | NONE | |
| US 2019109740 | A1 | 11-04-2019 | NONE | |

EPO FORM P0459

For more details about this annex : see Official Journal of the European Patent Office, No. 12/82